# EUROPEAN PATENT APPLICATION

(11) **EP 3 792 768 A1**
(43) Date of publication of application: **17.03.2021**
(21) Application number: 20165538.8
(22) Date of filing: 25.03.2020
(51) Int. Cl.: G06F 11/34, G06F 11/36, B60W 60/00

(54) **METHOD FOR CONSTRUCTING TEST SCENARIO LIBRARY, ELECTRONIC DEVICE AND MEDIUM**

(30) Priority: 12.09.2019 CN 201910867092
(71) Applicant: Baidu Online Network Technology (Beijing) Co., Ltd., Beijing 100085 (CN)
(72) Inventor: CAI, Jiakun, Beijing 100085 (CN)
(74) Representative: Zimmermann, Tankred Klaus

(57) **Abstract**

Embodiments of the present application disclose a method for constructing a test scenario library, an electronic device, and a medium which relate to a field of autonomous driving technology and may be used in a field of autonomous parking. The specific implementation is: determining (S110, S410) scenario categories of scenario elements, the scenario categories including a perceptual-type or a policy-type; selecting (S120, S220, S420) policy-type elements from the scenario elements each with the determined scenario category; constructing (S130, S430) a test scenario library according to the policy-type elements; and verifying (S140) the test scenario library, and updating the test scenario library according to a verification result.

## Description

### TECHNICAL FIELD

Embodiments of the present disclosure relate to a field of artificial intelligence technology, and particularly to a field of autonomous driving technology, which can be applied to a field of autonomous parking, and more particularly to a method for constructing a test scenario library, an electronic device, and a medium.

### BACKGROUND

Testing on autonomous driving vehicles must be performed based on certain test scenarios. At present, a classification dimension of scenario elements is only based on artificial understandings of objective world, roughly listing the scenario elements on various dimensions, for example, environment, ground features, and three-dimensional features or the like. The number of test scenarios obtained after cross-combination of the scenario elements on various dimensions has increased dramatically, and many test scenarios are actually non-existent and invalid, or substantially repeated scenarios. Further, a construction of a current test scenario library fails to focus on the scenarios that really need to be tested, thereby reducing a validity of test scenarios and an accuracy of subsequent tests.

### SUMMARY

Embodiments of the present application provide a method for constructing a test scenario library, an electronic device and a medium.

In a first aspect, an embodiment of the present application provides a method for constructing a test scenario library, including: determining scenario categories of scenario elements, in which the scenario categories include a perceptual-type or a policy-type; selecting policy-type elements from the scenario elements each with the determined scenario category; constructing a test scenario library according to the policy-type elements; verifying the test scenario library, and updating the test scenario library according to a verification result.

The above embodiment of the present disclosure has the following advantages or beneficial effects: the scenario elements are divided into the perceptual-type and the policy-type in advance, and the perceptual-type elements that have no substantial impact on autonomous driving are removed from the scenario elements while only the policy-type elements each with a substantial impact on autonomous driving are selected to construct a test scenario library, which releases coupling between the perceptual-type elements and policy-type elements, such that the test scenarios library focuses on the scenarios that really need to be tested, thereby greatly reducing the number of test scenarios, avoiding construction of invalid scenarios and repeated scenarios, and improving the validity of test scenarios and the accuracy of subsequent tests.

Alternatively, determining the scenario categories of the scenario elements includes: performing semantic understanding on the scenario elements; and determining the scenario categories of the scenario elements by classifying according to the semantic understanding of the scenario elements.

Alternatively, the policy-type elements is an element used to describe a scenario and related to a driving decision of an autonomous driving vehicle, and the perceptual-type element is an element used to describe the scenario and unrelated to the driving decision of the autonomous driving vehicle.

The above embodiment of the present disclosure has the following advantages or beneficial effects: the scenario elements are classified from the perspective of whether they have a substantial impact on autonomous driving vehicles, so as to clarify the scenario elements having a substantial impact on autonomous driving vehicles and the scenario elements having no substantial impact on autonomous driving vehicles.

Alternatively, constructing the test scenario library according to the policy-type elements includes: layering the policy-type elements, in which layers of the policy-type elements include a structure layer, an obstacle layer, and a vehicle behavior layer; arbitrarily combining the policy-type elements in at least one layer to construct a test scenario; and constructing the test scenario library according to the test scenario.

The above embodiment of the present disclosure has the following advantages or beneficial effects: by screening out the policy-type elements, using only the policy-type elements to construct the test scenario library, and arbitrary combining elements between each layer, the test scenario library focuses on the scenarios that really need to be tested, thereby greatly reducing the number of test scenarios, avoiding construction of invalid scenarios and repeated scenarios, and improving the validity of test scenarios.

Alternatively, verifying and updating the test scenario library includes: performing scenario simulation on a target test scenario in the test scenario library to verify a validity of the target test scenario; and performing a real-vehicle test on an autonomous driving vehicle based on a validated target test scenario, and updating the test scenario library according to a result of the real-vehicle test.

The above embodiment of the present disclosure has the following advantages or beneficial effects: the accuracy of scenario tests may be improved and the test scenario library may be improved by performing simulation and real-vehicle tests on the target test scenario in the test scenario library so as to combine theoretical tests with actual tests.

Alternatively, performing the real-vehicle test on the autonomous driving vehicle based on the validated target test scenario and updating the test scenario library according to the result of the real-vehicle test, includes: performing a closed real-vehicle test on the autonomous driving vehicle based on the target test scenario, and correcting the scenario elements in the test scenario library according to a result of the closed real-vehicle test; and performing an opened real-vehicle test on the autonomous driving vehicle according to an actual road scenario, and updating the scenario elements in the test scenario library according to a result of the opened real-vehicle test.

Alternatively, performing the closed real-vehicle test on the autonomous driving vehicle based on the target test scenario and correcting the scenario elements in the test scenario library according to the result of the closed real-vehicle test, includes: collecting real-vehicle driving parameters of the scenario elements in the target test scenario by performing the closed real-vehicle test on the autonomous driving vehicle according to the target test scenario; determining errors between the real-vehicle driving parameters and standard driving parameters of the scenario elements, by comparing the real-vehicle driving parameters with the standard driving parameters; and correcting the standard driving parameters of the scenario elements according to the errors between the real-vehicle driving parameters and the standard driving parameters.

Alternatively, performing the opened real-vehicle test on the autonomous driving vehicle according to the actual road scenario and updating the scenario elements in the test scenario library according to the result of the opened real-vehicle test, includes: determining the result of the real-vehicle test by performing the opened real-vehicle test on the autonomous driving vehicle according to the actual road scenario; determining a candidate scenario element that does not exist in the test scenario library by comparing the scenario elements in the actual road scenario with the scenario elements in the test scenario library, when it is determined according to the result of the real-vehicle test that the opened real-vehicle test in the actual road scenario fails; and adding the candidate scenario element to the test scenario library.

The above embodiment of the present disclosure has the following advantages or beneficial effects: the scenarios in the test scenario library are verified and corrected by means of the closed real-vehicle test, and scenario elements and scenarios in the test scene library are completed by means of the opened real-vehicle test.

In a second aspect, an embodiment of the present application provides an apparatus for constructing a test scenario library, including: an element classification module, for determining scenario categories of scenario elements, in which the scenario categories include a perceptual-type or a policy-type; an element selection module, for selecting policy-type elements from the scenario elements each with the determined scenario category; a scenario library construction module, for constructing a test scenario library according to the policy-type elements; and a scenario library updating module, for verifying the test scenario library, and updating the test scenario library according to a verification result.

In a third aspect, an embodiment of the present application provides an electronic device, including: at least one processor; and a memory connected in communication with the at least one processor. The memory has instructions stored thereon which are executable by the at least one processor, and when the instructions are executed by the at least one processor, so that the at least one processor is capable of executing the method for constructing a test scenario library described in any embodiment of the present application.

In a fourth aspect, an embodiment of the present application provides a non-transitory computer-readable storage medium having computer instructions stored thereon, the computer instructions are used to cause a computer to execute the method for constructing a test scenario library described in any embodiment of the present application.

The above embodiment of the present disclosure has the following advantages or beneficial effects: the scenario elements are divided into the perceptual-type and the policy-type in advance, and based on the classification results of scenario elements, the policy-type elements are selected to construct the test scenario library, and the test scenario library is updated based on the verification of the test scenario library. Because the technical means of classifying the scenario elements based on the perceptual-type and the policy-type is adopted, the technical problem of the sharp increase in the number of test scenarios caused by perceptual-type elements in the scenario elements that have no substantial impact on autonomous driving is overcome. Only the policy-type elements with a substantial impact on autonomous driving are selected to construct the test scenario library, which releases the coupling between the perceptual-type elements and policy-type elements, such that the test scenarios library focuses on the scenarios that really need to be tested, thus greatly reducing the number of test scenarios, avoiding construction of invalid scenarios and repeated scenarios, and improving the validity of test scenarios and the accuracy of subsequent tests.

Other effects of the above-mentioned alternative manners will be described below in conjunction with the detailed embodiments.

### BRIEF DESCRIPTION OF THE DRAWINGS

The drawings are used to better understand the present solution, and do not constitute a limitation on the present application, wherein:
FIG. 1 is a flow chart of a method for constructing a test scenario library according to a first embodiment of the present application;
FIG. 2 is a flow chart of a method for constructing a test scenario library according to a second embodiment of the present application;
FIG. 3 is an example diagram of layering policy-type elements in an application scenario according to a second embodiment of the present application;
FIG. 4 is a flow chart of a method for constructing a test scenario library according to a third embodiment of the present application;
FIG. 5 is a structural schematic diagram of an apparatus for constructing a test scenario library according to a fourth embodiment of the present application;
FIG. 6 is a block diagram of an electronic device used to implement the method of constructing the test scenario library in the embodiment of the present application.

### DETAILED DESCRIPTION

The following describes example embodiments of the present application in conjunction with the accompanying drawings, in which various details of embodiments of the present application are included to facilitate understanding, and they should be considered as merely exemplary. Therefore, those of ordinary skill in the art should recognize that various changes and modifications may be made to the embodiments described herein without departing from the scope and spirit of the present application. Also, for clarity and conciseness, descriptions of well-known functions and structures are omitted in the following description.

### First Embodiment

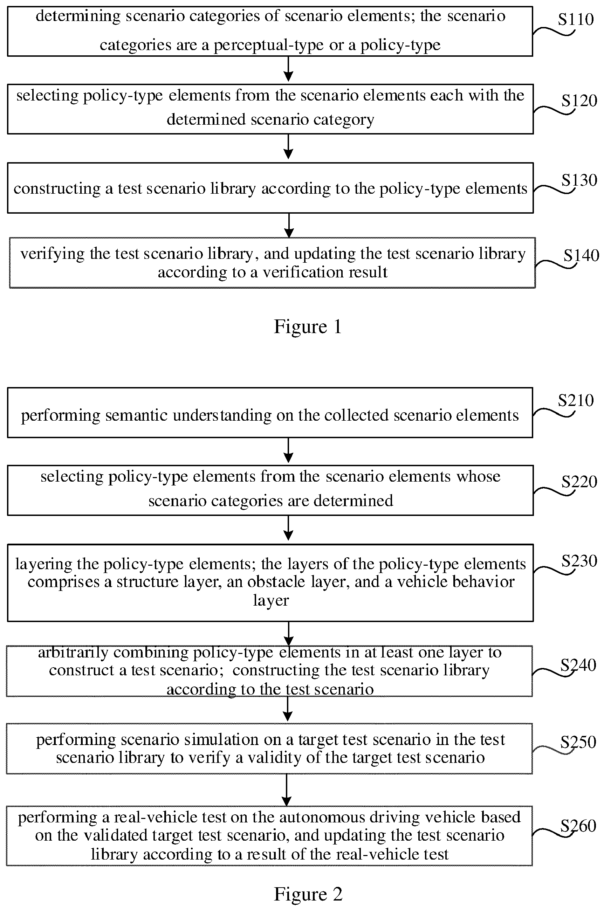

FIG. 1 is a flow chart of a method for constructing a test scenario library according to a first embodiment of the present application. The present embodiment is applicable to a case of constructing a test scenario library for testing an autonomous driving vehicle. The method may be performed by an apparatus for constructing a test scenario library, which may be implemented in software and/or hardware, and be preferably configured in an electronic device. As shown in FIG. 1, the method specifically includes the following.

At block S110, scenario categories of scenario elements are determined. The scenario categories include a perceptual-type or a policy-type.

In a specific embodiment of the present application, a scenario element refers to a minimum unit for constructing a scenario, for describing specific contents of a certain aspect of the scenario, such as the weather is sunny, the obstacle is an adult, the safety distance is 20cm, the lane is straight, or the driving behavior is to turn left.

In this embodiment, the current classification manner where scenario elements are divided into object, road condition, environment, and behavior only based on human subjective understanding is improved, and the scenario elements are then fundamentally re-divided. Since the test scenario in the embodiment is used to test an autonomous driving vehicle, the scenario categories of scenario elements are re-divided into the perceptual-type and the policy-type in the embodiment. Among them, the policy-type element is an element used to describe a scenario and related to a driving decision of an autonomous driving vehicle, i.e., a necessary element that has a decisive role in the driving decision of autonomous driving vehicle. The judgment without the policy-type elements will affect the driving safety of autonomous driving vehicle, for example, a position and a movement status of an obstacle. The perceptual element is an element used to describe a scenario and unrelated to a driving decision of an autonomous driving vehicle, i.e., an unnecessary element that does not have a decisive role in the driving decision of autonomous driving vehicle, for example, color of the obstacle.

Exemplarily, based on a structure of an autonomous driving vehicle, the autonomous driving vehicle commonly has a decision control module for issuing a driving control instruction according to information on the scenario elements. Correspondingly, the policy-type elements are the necessary input information of the decision control module, and the perceptual-type elements are the unnecessary input information of the decision control module. The policy-type elements may include information on, such as road structure, lane type, position, type (i.e., a person or a car, etc.) and movement status of the obstacle, position, driving behavior and driving parameters of the vehicle itself. The perceptual-type elements may include pedestrians of all ages (such as young children, children, youth, middle-aged or elderly), clothing colors of pedestrians and vehicle colors (such as black, red, white), postures of pedestrians (such as standing, sitting, squatting, groveling, lying,) and shadows (such as shade of a tree, projection of buildings). It can be seen that for such obstacle as a pedestrian, it only needs to obtain scenario elements of the pedestrians when the autonomous driving vehicle makes the driving control instruction, while clothing colors and postures of the pedestrians do not affect the driving behavior of the autonomous driving vehicle.

Specifically, in the embodiment, scenario elements may be collected as much as possible by means of vehicles, images, vision, networks, etc., and various scenario elements may be converted into text information, thereby identifying the semantics of scenario elements and classifying the scenario elements based on semantic understanding. For example, if a certain scenario element is red clothing, the scenario category of the scenario element may be determined as the perceptual-type based on a pre-specified classification rule and an association between the clothing color and the limited object (i.e., a pedestrian).

At block S120, policy-type elements are selected from the scenario elements each with the determined scenario category.

In a specific embodiment of the present application, the perceptual-type elements and the policy-type elements are obtained by classifying the scenario elements. Here, only the policy-type elements are selected for the construction of the test scenario library while the perceptual-type elements are removed.

At block S 130, a test scenario library is constructed according to the policy-type elements.

In a specific embodiment of the present application, the test scenario library refers to a material library for testing autonomous driving vehicles, and the test scenario library includes respective test scenarios, which may be constructed based on the scenario elements. Generally, the scenario elements in at least one dimension are arbitrarily combined to complete the construction of each test scenario. In this embodiment, since the perceptual-type elements are removed, the coupling between the perceptual-type elements and the policy-type elements is released during the construction of test scenarios based on the policy-type elements, such that combinations of the perceptual-type elements having no substantial impact on automatic driving, which are invalid and repeated for scenario construction, are greatly reduced.

Exemplarily, it is assumed that the policy-type elements include straight roads and pedestrians, and the perceptual-type elements include red clothing and black clothing. If the perceptual-type elements are retained, scenario 1 is obtained where a pedestrian is on a straight road, scenario 2 is obtained where a pedestrian clothed in red is on a straight road, and scenario 3 is obtained where a pedestrian clothed in black is on a straight road. It can be seen that only Scenario 1 is needed to be identified during the autonomous driving. Scenarios 2 and 3 are substantially the same as Scenario 1 and will not affect the issuing of driving instructions for autonomous driving vehicles. It should be understood that the number of perceptual-type elements in a real scenario are considerable and is not only limited to the above examples, so the number of scenarios constructed based on all the elements will inevitably increase exponentially, reducing the validity of the scenarios. In the case of removing the perceptual-type elements, only Scenario 1 is obtained where a pedestrian is on a straight road. The scenario elements and the scenarios they build are completely focused on the elements that only have a substantial impact on the autonomous driving, thereby reducing the number of scenarios and improving the validity of the scenarios.

Specifically, during the construction of the test scenario library based on the policy-type elements, the policy-type elements may be further layered, such as a structure layer, an obstacle layer, and a vehicle behavior layer, which facilitates constructing various test scenarios and building the test scenario library by arbitrarily combining the policy-type elements in at least one layer.

At block S140, the test scenario library is verified and updated according to a verification result.

In a specific embodiment of the present application, test scenarios in the test scenario library may be simulated using a computer, to verify the validity of the test scenarios, for example, whether the test scenario constructed based on respective elements is reasonable and consistent with a real scenario. For the test scenario validated by simulation, a real-vehicle test may be further conducted based on the autonomous driving vehicle to verify whether the vehicle has an automatic driving function associated with the test scenario, whether the parameters in the test scenario are correct, and whether the test scenario library includes complete test scenarios. Among them, for the case where it is verified that the autonomous driving vehicle has the automatic driving function, it may be further added to the full vehicle test; for the case where there are errors in parameters of the verified test scenario, the scenario elements may be further corrected; for the test scenarios not available in the test scenario library, the corresponding scenario elements and the test scenarios they build may be added to the test scenario library. Based on the verification of the test scenario library, the test scenario library is gradually improved.

In the technical solution of this embodiment, the scenario elements are divided into the perceptual-type and the policy-type in advance, and based on the classification result of scenario elements, the policy-type elements are selected to construct the test scenario library, and the test scenario library is updated based on the verification of the test scenario library. Because the technical means of classifying the scenario elements based on the perceptual-type and the policy-type is adopted, the technical problem of the sharp increase in the number of test scenarios caused by the perceptual-type elements in the scenario elements that have no substantial impact on the autonomous driving is overcome. Only the policy-type elements with a substantial impact on the autonomous driving are selected to construct the test scenario library, such that the test scenario library focuses on the scenarios that really need to be tested, thus greatly reducing the number of test scenarios, avoiding the construction of invalid scenarios and repeated scenarios, and improving the validity of test scenarios and the accuracy of subsequent tests.

### Second Embodiment

FIG. 2 is a flow chart of a method for constructing a test scenario library according to a second embodiment of the present application. This embodiment further explains the construction of the test scenario library on the basis of the first embodiment described above, wherein the policy-type elements may be layered and test scenarios may be constructed based on any combination of elements between each layer. As shown in FIG. 2, the method specifically includes the following.

At block S210, semantic understanding is performed on the collected scenario elements; the scenario categories of the scenario elements are determined based on a classification according to the semantic understanding of the scenario elements.

In a specific embodiment of the present application, scenario elements may be collected as much as possible by means of vehicles, images, vision, networks, etc., and various scenario elements may be converted into text information. For example, based on the vehicles with normal driving behaviors such as private cars or taxis, the vehicle and environmental information collected within the vehicles is actively uploaded to collect the scenario information transmitted by the vehicles; or the driving images of vehicles are collected based on driving recorders, eagle eyes, or monitors, the scenario information such as information on vehicles, roads or environments is collected based on vision.

In this embodiment, a classification rule may be pre-specified based on semantic understanding, for example, the associations between scenario elements and limited objects may be established in advance, such that the scenario elements may be classified based on the semantic understanding and the pre-established classification rule after identifying semantics of the scenario elements. For example, if a certain scenario element is red clothing, the scenario category of the scenario element may be determined as the perceptual-type based on the pre-specified classification rule and the association between the clothing color and the limited object (i.e., a pedestrian).

At block S220, the policy-type elements are selected from the scenario elements whose scenario categories are determined.

At block S230, the policy-type elements are layered. Layers of the policy-type elements include a structure layer, an obstacle layer, and a vehicle behavior layer.

In a specific embodiment of the present application, the policy-type elements may be layered from the dimensions of road structures, obstacles, and behaviors of the vehicle itself, so as to obtain the structure layer, the obstacle layer, and the vehicle behavior layer. Among them, the structure layer is used to describe the road structure, which may include scenario elements such as straight roads, right and obtuse bends, intersections, inclined parking, line parking; the obstacle layer is used to describe the obstacles on the road that affect driving of vehicles, which may include scenario elements such as pedestrians, non-motor vehicles, motor vehicles, positions, movement status; the vehicle behavior layer is used to describe the autonomous driving behaviors of the vehicle itself, which may include a behavior element such as going straight, turning left, or turning right, may also include a position element of the vehicle itself such as a left side, a right side and a center of the lane, and may also include driving parameter elements of the vehicle itself such as a vehicle speed. The road may be an outdoor road or an indoor road, such as an underground parking or a tunnel.

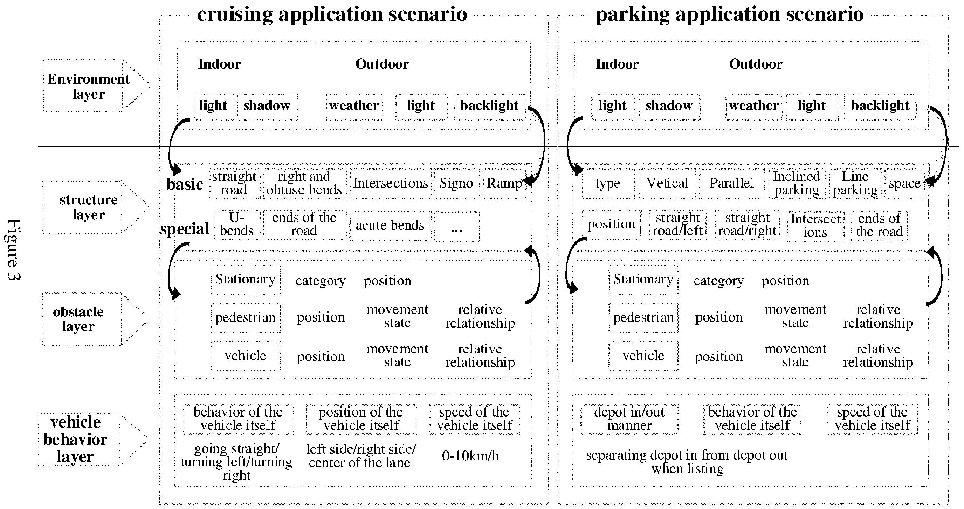

Exemplarily, during the construction of the test scenario library, in order to improve the test efficiency of the test scenario library, it is also possible to further divide the policy-type elements for various application scenarios of the autonomous driving, so that the respective test scenario library is used to test in various application scenarios, thus avoiding invalid tests of irrelevant scenarios. In this way, the layering of the policy-type elements and the construction of scenarios are performed in respective application scenarios. FIG. 3 is an example diagram of layering policy-type elements in an application scenario according to a second embodiment of the present application. As shown in FIG. 3, a cruising application scenario and a parking application scenario in the AVP (Auto Valet Parking) application scenario are taken as an example. The cruising may refer to a process that an autonomous driving vehicle drives out of a parking zone to find a user under an instruction of the user; the parking may refer to a process that an autonomous driving vehicle goes to the parking zone under an instruction of the user. The perceptual-type elements in the application scenario are determined as the environment layer, and the policy-type elements are layered into the structure layer, the obstacle layer, and the vehicle behavior layer. According to FIG. 3, based on the difference between the cruising application scenario and the parking application scenario, the scenario elements in the structure layer also differ, and the scenario elements in corresponding vehicle behavior layer also differ.

At block S240, the policy-type elements in at least one layer are arbitrarily combined to construct a test scenario. The test scenario library is constructed based on the test scenario.

In a specific embodiment of the present application, a total of at least two policy-type elements are selected from at least one layer for arbitrary combination to construct each test scenario, and at least one test scenario constructs a test scenario library. Specifically, scenario elements in the same layer may be combined, or scenario elements in different layers may be cross-combined. Accordingly, the more scenario elements combined, the more complex the test scenario constructed by the combination. The combination of scenario elements may be longitudinal stacking or lateral stitching of the scenario elements. This embodiment does not limit the combination of scenario elements, and any combination capable of combining scenario elements into a reasonable test scenario may be applied to this embodiment. For example, in FIG. 3, a straight road in the structural layer and a pedestrian in the obstacle layer constitute a scenario where a pedestrian is on a straight road; for another example, a straight road in the structural layer and a stationary pedestrian in the obstacle layer constitute a scenario where a stationary pedestrian is on a straight road. A straight road and a U-bend in the structure layer constitute a scenario of driving from a straight road into a U-bend; a right and obtuse bend in the structure layer and turning right in the vehicle behavior layer constitute a scenario of turning right at the obtuse-angle bend.

At block S250, scenario simulation is performed on a target test scenario in the test scenario library to verify a validity of the target test scenario.

In a specific embodiment of the present application, the target test scenario refers to a test scenario currently being verified in the test scenario library. The target test scenario may be simulated based on a computer to verify the validity of the target test scenario. Among them, it may be verified whether the target test scenario constructed based on each element is reasonable and consistent with the real scenario, for example, an obstacle may not appear in the target test scenario; it may also be verified whether the algorithm logic of each processing node in the target test scenario is effective, for example, for the specific value of safety distance element, whether the behavior of the vehicle itself is effective when a safety distance of the simulated vehicle is greater than this value, and whether the behavior of the vehicle itself is effective when it is less than this value.

At block S260, a real-vehicle test is performed on the autonomous driving vehicle based on the validated target test scenario, and the test scenario library is updated according to a result of the real-vehicle test.

In a specific embodiment of the present application, the real-vehicle test refers to a physical test performed by using a real autonomous driving vehicle. For the test scenario validated by simulation, a real-vehicle test may be further conducted based on the autonomous driving vehicle to verify whether the vehicle has the automatic driving function associated with the test scenario, whether the parameters in the test scenario are correct, and whether the test scenario library includes complete test scenarios. Among them, for the automatic driving function that the autonomous driving vehicle has through the verification, it may be further added to the full vehicle test. The closed real-vehicle test is performed by using the test scenarios present in the test scenario library, for the case where there are errors in parameters of the verified test scenario, the scenario elements may be further corrected. The opened test on real-vehicles is performed by using the actual road scenarios, for test scenarios not available in the test scenario library, the corresponding scenario elements and the test scenarios they build may be added to the test scenario library. Based on the verification of the test scenario library, the test scenario library is gradually improved.

In the technical solution of this embodiment, the scenario elements are divided into the perceptual-type and the policy-type in advance based on the semantic understanding of the collected scenario elements, the policy-type elements are selected to be layered and arbitrarily combined, so as to construct the test scenario and the test scenario library, and the test scenario library is updated based on the simulation on test scenarios library and the result of the real-vehicles test. The scenario elements are divided into the perceptual-type and the policy-type in advance; and the perceptual-type elements in the scenario elements that have no substantial impact on the autonomous driving are removed while only the policy-type elements with a substantial impact on the autonomous driving are selected to construct the test scenario library, which releases the coupling between the perceptual-type elements and the policy-type elements, such that the test scenarios library focuses on the scenarios that really need to be tested, thus greatly reducing the number of test scenarios, avoiding the construction of invalid scenarios and repeated scenarios, and improving the validity of test scenarios and the accuracy of subsequent tests. By means of simulation, verification and testing of the test scenario library, the scenario elements and scenarios of the test scenario library are continuously improved.

### Third Embodiment

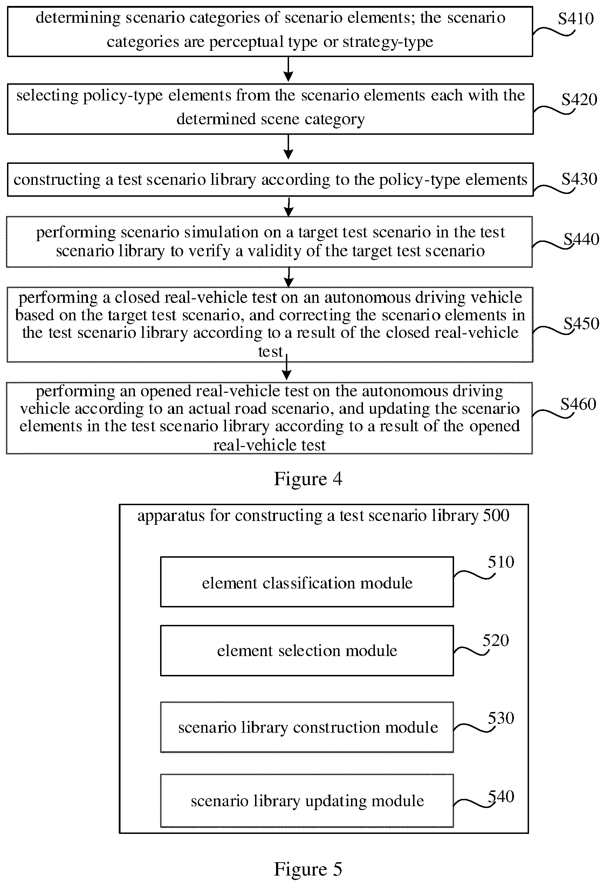

FIG. 4 is a flow chart of a method for constructing a test scenario library according to a third embodiment of the present application. This embodiment further explains the verification of the test scenario library on the basis of the first embodiment described above. The test scenario library may be updated based on the verification of the test scenario library. As shown in FIG. 4, the method specifically includes the following.

At block S410, scenario categories of scenario elements are determined. The scenario category may be a perceptual-type or a policy-type.

At block S420, policy-type elements are selected from the scenario elements each with the determined scenario category.

At block S430, a test scenario library is constructed according to the policy-type elements.

At block S440, scenario simulation is performed on a target test scenario in the test scenario library to verify a validity of the target test scenario.

At block S450, a closed real-vehicle test is performed on an autonomous driving vehicle based on the target test scenario, and the scenario elements in the test scenario library are corrected according to a result of the closed real-vehicle test.

In a specific embodiment of the present application, the closed real-vehicle test refers to a physical test performed by using a real autonomous driving vehicle based on existing test scenarios in the test scenario library. That is, the real-vehicle test on test scenarios in the test scenario library is implemented by the closed real-vehicle test, so as to correct the scenario elements that constitute the test scenarios in the test scenario library.

Alternatively, real-vehicle driving parameters of the scenario elements in the target test scenario are collected, by performing the closed real-vehicle test on the autonomous driving vehicle according to the target test scenario; the errors between the real-vehicle driving parameters and standard driving parameters are determined, by comparing the real-vehicle driving parameters with the standard driving parameters of the scenario elements; and the standard driving parameters of the scenario elements are corrected, according to the errors between the real-vehicle driving parameters and the standard driving parameters.

In this embodiment, based on different scenario elements, scenario elements may include indicators such as specific parameter values, for example, specific distance values associated with following distances between vehicles. In this embodiment, the indicators, such as theoretical parameter values associated with the scenario elements for constructing test scenarios in the test scenario library, are determined as the standard driving parameters. When the real-vehicle test is to be performed, the actual vehicle parameters under the scenario elements are obtained according to the perception of the autonomous driving vehicle, and are determined as the real-vehicle driving parameters. Then for the same scenario element, the real-vehicle driving parameter measured by the closed real-vehicle test in the target test scenario and the standard driving parameter are compared. Based on a preset error range, the standard driving parameter of the scenario element is corrected according to the actual error value if the error between the real-vehicle driving parameter and the standard driving parameter exceeds the preset error range.

Exemplarily, it is assumed that one of the test elements constituting the test scenarios in the test scenario library is a following distance, the standard driving parameter associated with the following distance element is 10m, and the error range of the following distance is 10±1m. If the actual following distance obtained by the closed real-vehicle test is 12m, the error between the actual driving parameter and the standard driving parameter is determined to be 2m, which exceeds the preset error range, and then the standard driving parameter is corrected based on the error, for example, properly increasing the value of standard following distance.

At block S460, an opened real-vehicle test is performed on the autonomous driving vehicle according to an actual road scenario, and the scenario elements in the test scenario library are updated according to a result of the opened real-vehicle test.

In a specific embodiment of the present application, the opened real-vehicle test refers to a physical test performed by using a real autonomous driving vehicle based on the actual road scenario. As the scenario elements in the actual road scenario are very complex, it may be verified based on the result of the real-vehicle test under the actual road scenario whether the scenario elements are complete for constructing the test scenarios in the test scenario library, so as to update the scenario elements for constructing the test scenarios in the test scenario library.

Alternatively, the result of the real-vehicle test is determined by performing the opened real-vehicle test on the autonomous driving vehicle according to the actual road scenario; a candidate scenario element that does not exist in the test scenario library is determined by comparing the scenario elements in the actual road scenario with the scenario elements in the test scenario library, if it is determined according to the result of the real-vehicle test that the test in the actual road scenarios fails; and the candidate scenario element is added to the test scenario library.

In this embodiment, it may be understood that the autonomous driving vehicle has the automatic driving function corresponding to each test scenario in the test scenario library, and it is assumed that the successful test of the autonomous driving vehicle can be achieved based on the real-vehicle test performed to the test scenario library, just with little numerical differences. However, if the test fails based on the actual road scenario, it indicates that the test scenario library lacks the collection of such scenario elements and construction of the actual road scenario and such elements are policy-type elements, which results in that autonomous driving vehicle does not have the functions associated with the actual road scenario. Therefore, if it is determined that the test in the actual road scenario fails according to the result of the real-vehicle test, the candidate scenario element that does not exist in the test scenario library is determine by comparing the scenario elements in the actual road scenario with the scenario elements in the test scenario library; and the candidate scenario element is added to the test scenario library, to gradually supplement the scenario elements in the test scenario library as well as the test scenarios constructed based on the scenario elements.

The technical solution of this embodiment verifies and corrects the scenario elements for constructing the test scenarios in the test scenario library by means of the closed real-vehicle test; and the scenario elements for constructing the test scenarios in the test scenario library are completed by means of the opened real-vehicle test. Verification-based technical means further improves the validity of the test scenario library and the accuracy of subsequent tests.

### Four Embodiment

FIG. 5 is a structural schematic diagram of an apparatus for constructing a test scenario library according to a fourth embodiment of the present application. This embodiment is applicable to a case of constructing a test scenario library for testing an autonomous driving vehicle. The method for constructing the test scenario library described in any embodiments of the present application may be achieved by the apparatus. The apparatus 500 specifically includes the following: an element classification module 510, for determining scenario categories of scenario elements; in which the scenario categories are perceptual-type or policy-type; an element selection module 520, for selecting policy-type elements from the scenario elements each with the determined scenario category; a scenario library construction module 530, for constructing a test scenario library according to the policy-type elements; a scenario library updating module 540, for verifying the test scenario library, and updating the test scenario library according to a verification result.

Alternatively, the element classification module 510 is specifically configured for: performing semantic understanding on the collected scenario elements; and determining the scenario categories of the scenario elements based on a classification according to the semantic understanding of the scenario elements.

Alternatively, the policy-type element is an element used to describe a scenario and related to a driving decision of an autonomous driving vehicle, and the perceptual-type element is an element used to describe a scenario and unrelated to a driving decision of an autonomous driving vehicle.

Alternatively, the scenario library construction module 530 is specifically configured for: layering the policy-type elements; in which layers of the policy-type elements include a structure layer, an obstacle layer, and a vehicle behavior layer; arbitrarily combining the policy-type elements in at least one layer to construct a test scenario; and constructing the test scenario library according to the test scenario.

Alternatively, the scenario library updating module 540 is specifically configured for: performing scenario simulation on a target test scenario in the test scenario library to verify the validity of the target test scenario; and performing a real-vehicle test on an autonomous driving vehicle based on a validated target test scenario, and updating the test scenario library according to a result of the real-vehicle test.

Alternatively, the scenario library updating module 540 is specifically configured for: performing a closed real-vehicle test on the autonomous driving vehicle based on the target test scenario, and correcting the scenario elements in the test scenario library according to a result of the closed real-vehicle test; and performing an opened real-vehicle test on the autonomous driving vehicle according to an actual road scenario, and updating the scenario elements in the test scenario library according to a result of the opened real-vehicle test.

Alternatively, the scenario library updating module 540 is specifically configured for: collecting real-vehicle driving parameters of the scenario elements in the target test scenario by performing the closed real-vehicle test on the autonomous driving vehicle according to the target test scenario; determining errors between the real-vehicle driving parameters and standard driving parameters of the scenario elements, by comparing the real-vehicle driving parameters with the standard driving parameters; and correcting the standard driving parameters of the scenario elements according to the errors between the real-vehicle driving parameters and the standard driving parameters.

Alternatively, the scenario library updating module 540 is specifically configured for: determining the result of the real-vehicle test by performing the opened real-vehicle test on the autonomous driving vehicle according to the actual road scenarios; determining a candidate scenario element that does not exist in the test scenario library by comparing the scenario elements in the actual road scenarios with the scenario elements in the test scenario library, if it is determined according to the result of the real-vehicle test that the test in the actual road scenarios fails; and adding the candidate scenario element to the test scenario library.

The technical solution of this embodiment realizes the function of: the collection of scenario elements, the classification of scenario elements, the selection of policy-type elements, the construction of test scenarios, the construction of test scenario library, the testing and updating of test scenario library through the cooperation of various functional modules. The scenario elements are divided into the perceptual-type and the policy-type in advance; and the perceptual-type elements in the scenario elements that have no substantial impact on autonomous driving are removed while only the policy-type elements with a substantial impact on autonomous driving are selected to construct the test scenario library, which releases the coupling between the perceptual-type elements and policy-type elements, such that the test scenarios library focuses on the scenarios that really need to be tested, thus greatly reducing the number of test scenarios, avoiding the construction of invalid scenarios and repeated scenarios, and improving the validity of test scenarios and the accuracy of subsequent tests.

### Fifth Embodiment

According to an embodiment of the present application, the present application further provides an electronic device and a readable storage medium.

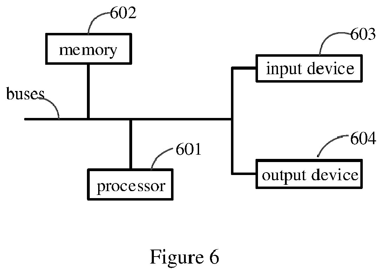

As shown in FIG. 6, it is a block diagram of an electronic device for the method of constructing the test scenario library in the embodiment of the present application. Electronic devices are intended to represent various forms of digital computers, such as laptop computers, desktop computers, workbenches, personal digital assistants, servers, blade servers, mainframe computers, and other suitable computers. Electronic devices may also represent various forms of mobile devices, such as personal digital processing, cellular phones, smart phones, wearable devices, and other similar computing devices. The components, their connections and relationships, and their functions shown herein are merely examples, and are not intended to limit the implementation of the present application described and/or required herein.

As shown in FIG. 6, the electronic device includes: one or more processors 601, a memory 602, and interfaces for connecting various components, including high-speed interfaces and low-speed interfaces. The various components are interconnected using different buses and may be mounted on a common motherboard or otherwise installed as required. A processor may process instructions executed within an electronic device, including instructions stored in a memory or on a storage to display graphical information for a graphical user interface (GUI) on an external input/output device, such as a display device coupled to an interface. In other embodiments, multiple processors and/or multiple buses may be used with multiple memories and multiple storages, if desired. Similarly, multiple electronic devices may be connected, each device providing part of the necessary operations, for example, as a server array, a set of blade servers, or a multi-processor system. One processor 601 is taken as an example in FIG. 6.

The memory 602 is a non-transitory computer-readable storage medium provided by the present application. Wherein, the memory has instructions stored thereon which are executable by at least one processor, so that the at least one processor executes the method for constructing the test scenario library provided by the present application. The non-transitory computer-readable storage medium of the present application stores computer instructions, which are used to cause a computer to execute the method for constructing the test scenario library provided by the present application.

As a non-transitory computer-readable storage medium, the memory 602 may be used to store non-transitory software programs, non-transitory computer executable programs, and modules, like the program instructions/modules corresponding to the method for constructing test scenario library in the embodiment of the present application, for example, the element classification module 510, the element selection module 520, the scenario library construction module 530, and the scenario library updating module 540 as shown in FIG. 5. The processor 601 executes various functional applications and data processing of the server by running the non-transitory software programs, instructions and modules stored in the memory 602, i.e., to implement the method for constructing the test scenario library as described in the above embodiment.

The memory 602 may include a storage program area and a storage data area, where the storage program area may store an operating system and an application program required for at least one function; the storage data area may store the data created according to the use of electronic device for the method of constructing the test scenario library, etc. In addition, the memory 602 may include a high-speed random access memory, and may also include a non-transitory memory, for example, at least one magnetic disk storage device, a flash memory device, or other non-transitory solid-state storage device. In some embodiments, the memory 602 may alternatively include a memory remotely set relative to the processor 601, and these remote memories may be connected to the electronic device for the method of constructing the test scenario library through a network. Examples of the above network include, but are not limited to, the Internet, an intranet, a local area network, a mobile communication network, and combinations thereof.

The electronic device for the method of constructing the test scenario library may further include an input device 603 and an output device 604. The processor 601, the memory 602, the input device 603, and the output device 604 may be connected through a bus or otherwise. In FIG. 6, the connection through the bus is taken as an example.

The input device 603 may receive inputted numeric or character information, and generate key signal inputs related to user settings and function control of the electronic device for the method of constructing the test scenario library, for example input devices such as, a touch screen, a keypad, a mouse, a trackpad, a touch tablet, a pointing stick, one or more mouse buttons, a trackball, a joystick. The output device 604 may include a display device, an auxiliary lighting device, a haptic feedback device, and the like, wherein the auxiliary lighting device is, for example, a light emitting diode (Light Emitting Diode, LED); the haptic feedback device is, for example, a vibration motor. This display device may include, but is not limited to, a liquid crystal display (LCD), an LED display, and a plasma display. In some embodiments, the display device may be a touch screen.

Various implementations of the systems and technologies described herein may be implemented in digital electronic circuit systems, integrated circuit systems, application specific integrated circuits (ASICs), computer hardware, firmware, software, and/or their combinations. These various embodiments may include: implemented in one or more computer programs, the one or more computer programs being executable and/or interpretable on a programmable system including at least one programmable processor, which may be a dedicated or general-purpose programmable processor that may receive data and instructions from a storage system, at least one input device, and at least one output device, and transmit the data and instructions to the storage system, the at least one input device, and the at least one output device.

These computing programs, also known as programs, software, software applications, or codes, include machine instructions of a programmable processor, and may utilize high-level processes and/or object-oriented programming languages, and/or assembly/machine languages to implement these calculation programs. As used herein, the terms "machine-readable medium" and "computer-readable medium" refer to any computer program product, device, and/or apparatus used to provide machine instructions and/or data to a programmable processor, for example, magnetic disks, optical disks, memories, and programmable logic devices (PLDs), and include machine-readable media that receive machine instructions as machine-readable signals. The term "machine-readable signal" refers to any signal used to provide machine instructions and/or data to a programmable processor.

In order to provide interaction with the user, the systems and techniques described herein may be implemented on a computer having a display device for displaying information to the user, for example, a cathode ray tube (CRT) or LCD monitor; and a keyboard and pointing device, such as a mouse or trackball, through which the user may provide input to a computer. Other kinds of devices may also be used to provide interaction with the user; for example, the feedback provided to the user may be any form of sensory feedback, such as visual feedback, auditory feedback, or haptic feedback; and may be in any form, including acoustic input, voice input, or tactile input to receive inputs from the user.

The systems and technologies described herein may be implemented in computing systems that include back-end components, for example, data servers, or in computing systems that include middleware components, for example, application servers, or in computing systems that include front-end components, for example, a user computer with a graphical user interface or a web browser, through which the user may interact with the implementations of systems and technologies described herein, or implemented in computing systems in that include any combination of such background components , middleware components, or front-end components. The components of the system may be connected to each other through digital data communication in any form or medium, for example, communication networks. Examples of communication networks include: a local area network (LAN), a wide area network (WAN), and the Internet.

Computer systems may include clients and servers. The client and server are generally remote from each other and typically interact through communication networks. The client-server relationship is generated by computer programs running on the respective computers and having a client-server relationship with each other.

According to the technical solution of the embodiment of the present application, the scenario elements are divided into perceptual-type and policy-type in advance, and based on the classification result of scenario elements, the policy-type elements are selected to construct the test scenario library, and the test scenario library is updated based on the verification of the test scenario library. Because the technical means of classifying the scenario elements based on the perceptual-type and the policy-type is adopted, the technical problem of the sharp increase in the number of test scenarios caused by the perceptual-type elements in the scenario elements that have no substantial impact on autonomous driving is overcome. Only the policy-type elements with a substantial impact on autonomous driving are selected to construct a test scenario library, which releases the coupling between the perceptual-type elements and policy-type elements, such that the test scenarios library focuses on the scenarios that really need to be tested, thus greatly reducing the number of test scenarios, avoiding the construction of invalid scenarios and repeated scenarios, and improving the validity of test scenarios and the accuracy of subsequent tests.

In addition, the above embodiment in the application has the following advantages or beneficial effects: the scenario elements are classified from the perspective of whether they have a substantial impact on autonomous driving vehicles, so as to clarify the scenario elements having a substantial impact on autonomous driving vehicles and the scenario elements having no substantial impact on autonomous driving vehicles.

In addition, the above embodiment of the application has the following advantages or beneficial effects: only the policy-type elements are used by selection to construct the test scenario library, and the test scenario library is focused on the scenarios that really need to be tested based on arbitrary combinations of elements between each layer, thereby greatly reducing the number of test scenarios, avoiding the construction of invalid scenarios and repeated scenarios, and improving the validity of test scenarios.

In addition, the above embodiment in the application has the following advantages or beneficial effects: the accuracy of scenario tests may be improved and the test scenario library may be improved by performing simulation and real-vehicle tests on the target test scenarios in the test scenario library so as to combine theoretical tests with actual tests.

In addition, the above embodiment of the application has the following advantages or beneficial effects: the scenarios in the test scenario library are verified and corrected by means of the closed real-vehicle tests, and scenario elements and scenarios in the test scene library are completed by means of the opened real-vehicle tests.

It should be understood that the various forms of processes shown above may be used to reorder, add, or delete steps. For example, the steps described in this application may be executed in parallel, sequentially, or in different orders. As long as the desired results of the technical solutions disclosed in this application may be achieved, there is no limitation herein.

The foregoing specific implementations do not constitute a limitation on the protection scope of the present application. It should be understood by those skilled in the art that various modifications, combinations, sub-combinations, and substitutions may be made according to design requirements and other factors. Any modification, equivalent replacement and improvement made within the spirit and principle of the present application shall be included in the protection scope of the present application.

## Claims

1. A method for constructing a test scenario library, comprising:
determining (S110, S410) scenario categories of scenario elements, wherein the scenario categories comprise a perceptual-type or a policy-type;
selecting (S120, S220, S420) policy-type elements from the scenario elements each with the determined scenario category;
constructing (S130, S430) a test scenario library according to the policy-type elements; and
verifying (S140) the test scenario library, and updating the test scenario library according to a verification result.

2. The method according to claim 1, wherein, determining (S110) the scenario categories of the scenario elements comprises:
performing (S210) semantic understanding on the scenario elements; and
determining the scenario categories of the scenario elements by classifying according to the semantic understanding of the scenario elements.

3. The method according to claim 1, wherein the policy-type element is an element used to describe a scenario and related to a driving decision of an autonomous driving vehicle, and the perceptual-type element is an element used to describe the scenario and unrelated to the driving decision of the autonomous driving vehicle.

4. The method according to claim 1, wherein, constructing (S130) the test scenario library according to the policy-type elements comprises:
layering (S230) the policy-type elements, wherein layers of the policy-type elements comprise a structure layer, an obstacle layer, and a vehicle behavior layer;
arbitrarily combining (S240) the policy-type elements in at least one layer to construct a test scenario; and
constructing the test scenario library according to the test scenario.

5. The method according to claim 1, wherein, verifying (S140) the test scenario library and updating the test scenario library comprises:
performing (S250, S440) scenario simulation on a target test scenario in the test scenario library to verify a validity of the target test scenario; and
performing (S260) a real-vehicle test on an autonomous driving vehicle based on a validated target test scenario, and updating the test scenario library according to a result of the real-vehicle test.

6. The method according to claim 5, wherein, performing (S260) the real-vehicle test on the autonomous driving vehicle based on the validated target test scenario, and updating the test scenario library according to the result of the real-vehicle test, comprises:
performing (S450) a closed real-vehicle test on the autonomous driving vehicle based on the target test scenario, and correcting the scenario elements in the test scenario library according to a result of the closed real-vehicle test; and
performing (S460) an opened real-vehicle test on the autonomous driving vehicle according to an actual road scenario, and updating the scenario elements in the test scenario library according to a result of the opened real-vehicle test.

7. The method according to claim 6, wherein, performing (S450) the closed real-vehicle test on the autonomous driving vehicle based on the target test scenario, and correcting the scenario elements in the test scenario library according to the result of the closed real-vehicle test, comprises:
collecting real-vehicle driving parameters of the scenario elements in the target test scenario by performing the closed real-vehicle test on the autonomous driving vehicle according to the target test scenario;
determining errors between the real-vehicle driving parameters and standard driving parameters of the scenario elements, by comparing the real-vehicle driving parameters with the standard driving parameters; and
correcting the standard driving parameters of the scenario elements according to the errors between the real-vehicle driving parameters and the standard driving parameters.

8. The method according to claim 6, wherein, performing (S460) the opened real-vehicle test on the autonomous driving vehicle according to the actual road scenario, and updating the scenario elements in the test scenario library according to the result of the opened real-vehicle test, comprises:
determining the result of the real-vehicle test by performing the opened real-vehicle test on the autonomous driving vehicle according to the actual road scenario;
determining a candidate scenario element that does not exist in the test scenario library by comparing the scenario elements in the actual road scenario with the scenario elements in the test scenario library, when it is determined according to the result of the real-vehicle test that the opened real-vehicle test in the actual road scenario fails; and
adding the candidate scenario element to the test scenario library.

9. An apparatus (500) for constructing a test scenario library, comprising:
an element classification module (510), for determining scenario categories of scenario elements, wherein the scenario categories comprise perceptual-type or policy-type;
an element selection module (520), for selecting policy-type elements from the scenario elements each with the determined scenario category;
a scenario library construction module (530), for constructing a test scenario library according to the policy-type elements;
a scenario library updating module (540), for verifying the test scenario library, and updating the test scenario library according to the verification results.

10. The apparatus (500) according to claim 9, wherein, the element classification module (510) is further configured for:
performing semantic understanding on the scenario elements; and
determining the scenario categories of the scenario elements by classifying according to the semantic understanding of the scenario elements.

11. The apparatus (500) according to claim 9, wherein the policy-type element is an element used to describe a scenario and related to a driving decision of an autonomous driving vehicle, and the perceptual-type element is an element used to describe the scenario and unrelated to the driving decision of the autonomous driving vehicle.

12. The apparatus (500) according to claim 9, wherein, the scenario library construction module (530) is further configured for:
layering the policy-type elements, wherein layers of the policy-type elements comprise a structure layer, an obstacle layer, and a vehicle behavior layer;
arbitrarily combining the policy-type elements in at least one layer to construct a test scenario; and
constructing the test scenario library according to the test scenario.

13. The apparatus (500) according to claim 9, wherein, the scenario library updating module (540) is further configured for:
performing scenario simulation on a target test scenario in the test scenario library to verify a validity of the target test scenario; and
performing a real-vehicle test on an autonomous driving vehicle based on a validated target test scenario, and updating the test scenario library according to a result of the real-vehicle test.

14. The apparatus (500) according to claim 13, wherein, the scenario library updating module (540) is further configured for:
performing a closed real-vehicle test on the autonomous driving vehicle based on the target test scenario, and correcting the scenario elements in the test scenario library according to a result of the closed real-vehicle test; and
performing an opened real-vehicle test on the autonomous driving vehicle according to an actual road scenario, and updating the scenario elements in the test scenario library according to a result of the opened real-vehicle test.

15. A non-transitory computer-readable storage medium having computer instructions stored thereon, wherein the computer instructions are used to cause a computer to execute the method for constructing a test scenario library according to any one of claims 1-8.
